# EUROPEAN PATENT SPECIFICATION

(11) **EP 0 361 959 B1**
(45) Date of publication and mention of the grant of the patent: **11.09.1996**
(21) Application number: 89309979.6
(22) Date of filing: 29.09.1989
(51) Int. Cl.: H01L 21/68

(54) **A substrate conveying apparatus**
Transportvorrichtung für Substrate
Dispositif de transport de substrats

(30) Priority: 30.09.1988 JP 246263/88; 30.09.1988 JP 246264/88
(43) Date of publication of application: 04.04.1990
(73) Proprietor: CANON KABUSHIKI KAISHA, Tokyo 146 (JP)
(72) Inventor: Matsui, Shin, Atsugi-shi Kanagawa-ken (JP); Kariya, Takao, Hino-shi Tokyo (JP); Mizusawa, Nobutoshi, Yamato-shi Kanagawa-ken (JP); Ebinuma, Ryuichi, Kawasaki-shi Kanagawa-ken (JP); Uzawa, Shunichi, Tokyo (JP)
(74) Representative: Beresford, Keith Denis Lewis

(56) References cited:
- EP-A- 0 244 202
- EP-A- 0 244 950
- EP-A- 0 246 453
- EP-A- 0 253 162
- EP-A- 0 278 460

## Description

The present invention relates to a substrate conveying apparatus for conveying a substrate such as a semiconductor wafer in a semiconductor manufacturing apparatus, and more particularly to a substrate conveying apparatus for transferring a substrate to a substrate stage while it is maintained vertically, that is, while the surface of the substrate is extending vertically. Furthermore, the invention relates to a substrate conveying apparatus for picking up a substrate from and returning it to a substrate cassette for accommodating substrates horizontally.

In an X-ray exposure apparatus using as an exposure energy source synchrotron orbital radiation, as contrasted to a conventional exposure apparatus, a wafer and a mask are situated vertically, that is, the surface of the wafer and the mask are parallel to an XY plane in an X-Y-Z coordinates in which Y axis is vertical. In such an X-ray exposure apparatus, the wafer conveying system must match vertical X-Y stage. However, systems for the vertical arrangement are not developed well. On the other hand, in the wafer conveying system, the problem of foreign matter becomes more significant due to the demand for the reduction of the line width of the pattern to be transferred for the semiconductor devices, and therefore, a proposal has been made wherein a back side of the wafer is attracted by a conveying hand.

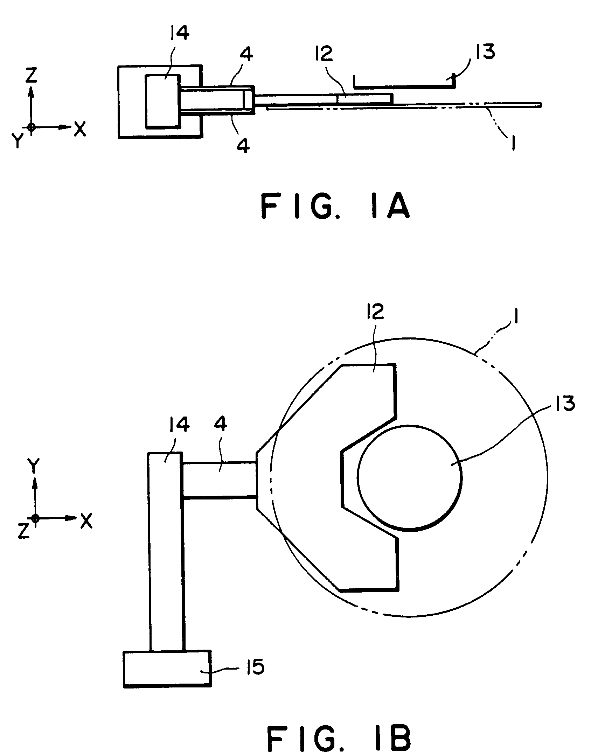

Figures 1A and 1B show a conventional conveying apparatus of a vertical type wherein the wafer is attracted at its back side. Figure 1A is a top plan view, and Figure 1B is a front view, wherein Y axis extends vertically. Reference numeral 1 designates a wafer. The apparatus comprises a conveying hand 12 for attracting and conveying the wafer 1, a wafer chuck 13 for supporting the wafer 1, a parallel link mechanism 4 to which the conveying hand 12 is mounted, a block 14 to which the parallel link mechanism 4 is mounted and a Z-stage 15 movable in the Z axis direction.

The wafer chuck 13 has a size smaller than the wafer 1 to permit the conveying hand 12 to attract the backside of the wafer 1. In addition, the conveying hand 12 does not interfere with the wafer chuck 13, but is still capable of attracting the wafer 1. Therefore, the wafer attracting areas and the attracting forces of the conveying hand 12 and the wafer chuck 13 are determined in consideration of them together.

In the above-described structure, when the wafer 1 supported by the conveying hand 12 is to be mounted on the wafer chuck 13, the Z-stage 15 is driven to a mounting position, while the position of the conveying hand 12 is being checked by an unshown sensor. At this time, the conveying hand 12 slightly presses the wafer 1 to the wafer chuck 13. Then, the attracting force of the wafer chuck 13 is produced, by which the wafer 1 is attracted on the wafer chuck 13. Subsequently, the attraction force by the conveying hand 12 is removed, by which the wafer 1 transfer is completed.

However, in the conventional vertical conveying system wherein the wafer is attracted at its backside, there arise the following problems with the result that it is difficult to assure the wafer to be conveyed to the stage:
(1) When the wafer 1 attracted at its backside is transferred to the wafer chuck 13 which also attracts the backside of the wafer 1, the parallelism has to be accurately established between the wafer attracting surface of the conveying hand 12 and the wafer supporting surface of the wafer chuck 13, since otherwise the wafer 1 is not transferred to the wafer chuck 13, or it is transferred with angular deviation:
(2) Since all the attractions are effected to the backside of the wafer, the conveying hand 12 has to have large attraction force, and a larger attracting area thereof is desired: however, in order to assure the sufficient attracting area of the wafer chuck 13, it is difficult to increase the attraction area of the conveying hand 12.

According to the present invention there is provided a substrate conveying apparatus according to claim 1.

Then, even if the substrate is slightly inclined when the substrate is transferred from the conveying hand to the substrate supporting means, the attitude of the substrate supported on the gimbal supporting mechanism is corrected to follow the substrate receiving surface when the substrate is pressed to the substrate receiving surface of the substrate supporting means.

It is preferable that at least a part of the substrate receiving surface of the substrate supporting means extends from the center of the substrate receiving surface beyond a supporting shaft of the gimbal supporting mechanism. As an example, the extension is in the form of a projection from a part of a circular receiving surface. By doing so, an angular deviation between the surface of the substrate attracted by the conveying hand and the substrate receiving surface of the substrate supporting means is accommodated with certainty. In addition, the substrate attracting area of the conveying hand is increased.

On the other hand, in a conventional wafer conveying system for manufacturing a semiconductor devices, the dimensional accuracy is not very good in the wafer cassette, and in addition, the conveying hand is not positioned with high precision, with the result of difficulty in picking a wafer up from a wafer cassette and returning it into the wafer cassette without abutment to a portion of the wafer cassette. Actually, in the conventional wafer conveyance, it is accepted as being unavoidable that the wafer is slid on the wafer cassette with the result of production of dusts, because the contact between the wafer and the wafer cassette is not a significant problem in the conventional system.

European Patent Application No. 0244202 proposes an apparatus for solving this problem. However, in that prior art arrangment the change in the attitude of the hand when the hand receives the wafer still results in an unavoidable slight change in the attitudes of the wafer, so that there is a substantial possibility of contact between the wafer and the cassette.

However, the recent improvement in the fine pattern production technique using a pattern exposure in the semiconductor manufacturing, the production of the dust by the sliding contact between the wafer and the wafer cassette becomes a significant problem, because the dust leads to the decrease of the yield of the semiconductor device manufacturing.

According to the present invention there is also provided a substrate conveying apparatus according to claim 3.

How the invention may be carried out will now be described by way of example only and with reference to the accompanying drawings in which:

### In the accompanying drawings:

Figures 1A and 1B are top plan view and a front view of a conventional conveying system.

Figures 2A and 2B are a top plan view and a front view of a conveying apparatus according to an embodiment of the present invention.

Figure 3 is a side view of a conveying apparatus according to another embodiment of the present invention.

Figure 4 is a side view of the apparatus of Figure 3 embodiment immediately before the attitude correction of the attracting hand.

Figure 5 is a side view of the apparatus of Figure 3 embodiment immediately after the attitude correction of the attracting hand.

Figure 6 is a side view of the apparatus of Figure 3 embodiment when the attracting hand is inserted into the wafer cassette after the attitude correction.

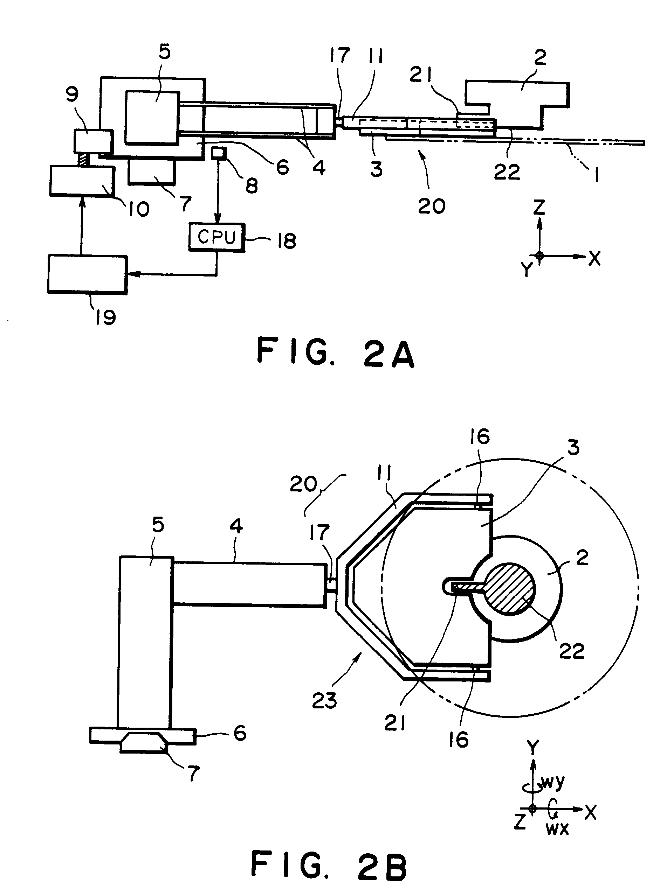

Referring to Figures 2A and 2B, there is shown a conveying apparatus according to an embodiment of the present invention. Figure 2A is a top plan view, and Figure 2B is a front view, wherein a Y axis extends vertically. In the Figures, reference numeral 1 designates a wafer.

The apparatus comprises a wafer chuck 2, an operating hand 3 for attracting and supporting a backside of the wafer 1, stage rails 7 and a stage 6 on the stage rails 7 with latitude in the Z axis direction. The apparatus further comprises a fixed block 5 on the stage 6, a parallel link mechanism 4 mounted on the fixed block 5 extending along the X axis (horizontally), and a conveying and attracting hand 20 to the free end of the parallel link mechanism 4 with latitude in the Z axis direction. The attracting hand 20 has a gimbal mechanism 23. The conveying attraction hand which will hereinafter be called "conveying hand" 20 including the gimbal mechanism 23 is constituted mainly by an operating hand 3 having a wafer attracting function, a rotatable supporting hand 11 having a generally V-shape, a Wy rotation shaft 16 mounted to lateral ends of the rotatable supporting hand 11 and extending parallel to the Y axis and a Wx rotation shaft 17 mounted to a free end side of the parallel link 4 and extending parallel to the X axis. The positions of the rotation shafts 16 and 17 are adjusted so that they are the same in the Z axis direction, that is, a plane including rotational center axes of the rotation shafts 16 and 17 is substantially parallel to the X-Y plane. The operating hand 3 is freely rotatable in the direction Wy relative to the rotational supporting hand 11 by the rotation shaft 16, and the rotatable supporting hand 11 is freely rotatable in the direction Wx relative to the parallel link mechanism 4 by the rotation shaft 17. Therefore, the operating hand 3 is freely rotatable in both of the directions Wx and Wy about the rotation shafts 16 and 17 relative to the parallel link mechanism 4. The operating hand is inside the rotatable supporting hand 11.

The conveying apparatus further includes a ball screw 9 and an actuator 10. The movement of the actuator 10 is converted into a rectilinear movement in the Z axis direction by the ball screw to drive the stage 6 in the Z axis direction. A sensor 8 is provided to be rendered on or off photoelectrically when the stage 6 is driven to a predetermined position in the Z axis direction. The apparatus further includes a CPU (central processing unit) 18 and a driver 19 for the actuator 10.

The wafer 1 is transferred to the chuck 2. The chuck 2 is provided with a projection 21 having the same level surface (the Z axis direction) as the chucking surface. The projection 21 extends in the X axis direction from the outer periphery of the chuck 2. The wafer supporting surface (attracting surface) includes the chucking surface and the surface of the projection, as indicated by hatched lines 22.

The operation will be described as to the wafer 1 transfer from the conveying hand 20 to the wafer chuck 2. The stage 6 is driven in the Z axis direction by the actuator 10 to advance the conveying hand 20 to such an extent that the backside of the wafer 1 is not contacted with the receiving surface 22 of the wafer chuck 2. At this position, the light to the sensor 8 is blocked. The CPU 18, in response to the light blocking of the sensor 8, instructs the driver 19 to produce predetermined pulses. The driver 19 supplies the predetermined pulses to the actuator 10, by which the stage 6 is further advanced through a predetermined distance in the Z axis direction from the position where the light to the sensor 8 is blocked. The predetermined pulses are so determined that the conveying hand 20 is advanced through several hundreds micrometers in the Z axis direction beyond the receiving surface 22 of the chuck 2, from the position where the light to the sensor 8 is blocked.

In this manner, the actuator 10 urges the conveying hand 20 to press the wafer 1 to the chuck 2 in response to the instructions of the CPU 18. At this time, the gimbal mechanism 23 of the conveying hand 20 accommodates the angular deviation between the surface of the operating hand 3 supporting the wafer 1 and the attracting surface 22 of the chuck 2. This is because, due to the gimbal mechanism 23 of the conveying hand 20 mounted to the parallel link 4, the operating hand 3 has rotational latitude in the direction Wx about the Wx rotation shaft 17 and also rotational latitude in the direction Wy about the Wy rotation shaft 16.

In order for the gimbal mechanism 23 to operate correctly, when the backside of the wafer 1 supported on the operating hand 3 is pressed to the attracting surface 22 of the wafer chuck 2, the Wx and Wy rotation shafts 16 and 17 are required to be overlapped with the attracted surface 22 of the wafer chuck 2. In other words, a line extended from the rotational shaft 16 in the Y axis direction in the X-Y plane, crosses a substantially central portion of the attracting surface 22, and a line extended from the rotation shaft 17 in the X axis direction, crosses substantially a central portion of the attracting surface 22. If the extensions in the X-Y plane of the rotation shafts 16 and 17 are outside the attracting surface 22 of the wafer chuck 2, the wafer 1 is rotated away from the attracting surface 22 without correcting the attitude along the attracting surface 22, when the backside of the wafer 1 is pressed to the attracting surface 22 of the wafer chuck 2.

On the other hand, the operating hand 3 conveys the wafer 1 while supporting or attracting it, and therefore, it is subjected to acceleration or impact. It is, therefore, desirable that the operating hand 3 has the attraction force which is larger than that of the chuck 2. In other words, the hand 3 preferably has an attracting area which is larger than the attracting area of the chuck 2.

In order to overlap the extensions, in the X-Y plane, of Wx and Wy rotation axes 16 and 17 with the attracting surface 22 of the chuck 2, it will be achieved by increasing the diameter of the attracting surface 22 of the chuck 2. Then, however, the attracting surface of the operating hand is reduced correspondingly, with the result of insufficient attraction force thereof.

In this embodiment, in order to satisfy the two requirements, the projection 21 shown in Figures 2A and 2B are provided having the same level surface as the chuck 2 attracting surface 22 in the Z axis direction. By the projection 21, the area of the attracting surface 22 can be made minimum, and Wy rotation axis 16 is prevented from being outside the attracting surface 22 of the chuck 2, because the extension, in the Y axis direction, of Wy rotation axis 16 is overlapped with the projected portion 21. When the wafer 1 is pressed to the chuck 2, the attitude of the wafer 1 is corrected to follow the attracting surface 22 of the chuck 2, since the extension, in the Y axis direction, of the Wy rotation axis 16 is overlapped with the attracting surface 22 of the chuck 2 by the provision of the projection 21. In addition, since the area of the attracting surface 22 is reduced, the attracting surface of the operating hand 3 has a larger and sufficient attracting area by the attracting area of the chuck 2.

After the operating hand 3 is pressed to the chuck 2 so that the backside of the wafer 1 and the attracting surface of the chuck 2 are contacted, the attraction by the chuck 2 is started. Subsequently, the attracting action of the operating hand 3 is stopped, by which the transfer of the wafer 1 is completed.

As described, according to this embodiment, the conveying hand includes the gimbal supporting mechanism, and the supporting or receiving surface of the substrate supporting means is provided with a projection in the form of a square rod, and therefore, the substrate is prevented from falling during conveyance and is transferred with certainty and reliability. In addition, since the structure is simple, the assembling of the apparatus is easy.

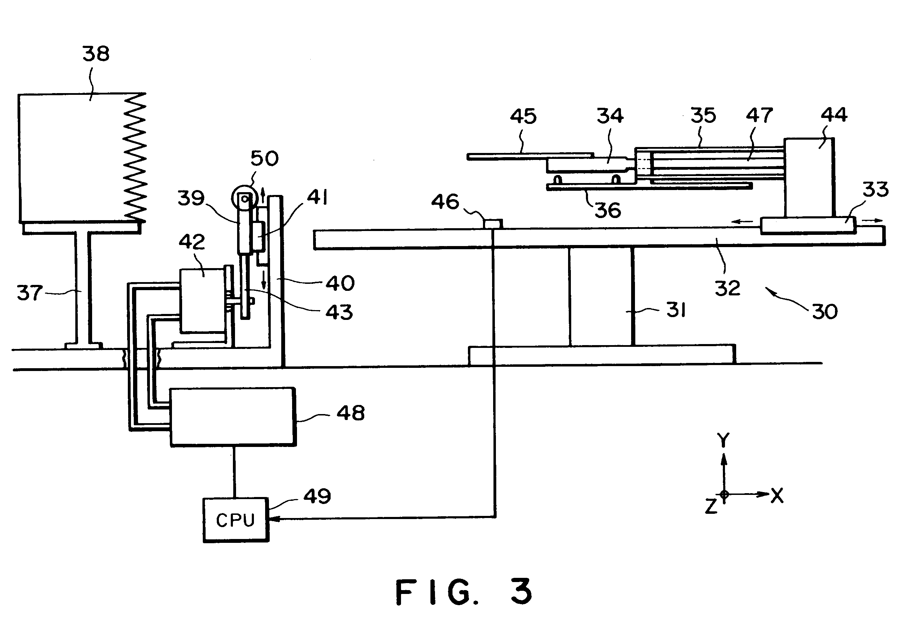

Referring to Figure 3, there is shown a conveying apparatus according to another embodiment of the present invention, in a side view. In this Figure, the Y axis also extends vertically.

The apparatus comprises a base 32 rotatable about an axis parallel to the Z axis by a rotating table 31, a stage 33 movable rectilinearly in a horizontal plane (Z axis direction in this Figure) on the base 32, a fixed block 44 fixed on the linear movement stage 33 and an attracting hand 34 for attracting a wafer 45 and for transferring the wafer 45 to and from a wafer cassette 38. The attracting hand is supported on an elastic member 47 fixed on the fixed block 44. The apparatus further comprises a hand locking plate 36 having three pins projecting out in the Y axis direction to correct the attracting surface of the attracting hand 34 and a parallel link mechanism 35 for moving the hand locking plate 36 up and down (Y axis direction) parallel to the attitude initially set. The hand locking plate 36 is fixed to the parallel link 35 at its central portion. The parallel link mechanism 35 is mounted to the fixed block 44. A conveying hand system 30 is constituted by the rotatable table 31, the base 32, the linearly movable stage 33, the fixed block 44, the parallel link mechanism 35, the hand locking plate 36, the elastic member 47 and the attracting hand 34. The wafer 45 is attracted by the attracting hand 34. A wafer cassette (wafer accommodating portion) 38 contains the wafer 45 and is fixed on a cassette table 37. An abutting rod 39 has a roller 50 rotatable about a rotational axis parallel to the Z axis. When the wafer 45 attracted on the attracting hand 44 comes to a position immediately before the wafer cassette 38, the abutting rod 39 abuts the roller 50 to the hand locking plate 36 to correct the attitude thereof. The abutting rod 39 is guided by a linear guide 41 in the Y axis direction (up and down direction in the Figure). The guide 41 is mounted on the mounting plate 40. To the mounting plate 40, the cassette table 37 is also fixed. The abutting rod 39 is advanced by an eccentric cam 43 through a predetermined distance in the Y axis direction, and the eccentric cam 43 is driven by an actuator 42. The apparatus further includes a photosensor 46, an electromagnetic valve 48 for driving and controlling the actuator 42, and a CPU 49 for controlling the electromagnetic valve 48 in response to an output of the photosensor 46. The photosensor 46 detects that the wafer attracted on the attracting hand 34 comes to a position immediately before the wafer cassette 38.

Next, the operation will be described as to when the wafer 45 is returned into the wafer cassette 38. A unit 30 containing the wafer attracting hand 4 attracting a wafer 45 which has been subjected to a pattern exposure operation in an unshown exposure apparatus is rotated by the rotatable table 31 to the wafer returning side wherein it is faced to the wafer cassette 38. Then, the linear stage 33 is driven to move the wafer 45 attracted on the attracting hand 34 to a position immediately before the wafer cassette 38 (the abutting rod 39 operating position) where it is stopped. At this time, the light to the photosensor 46 on the base 32 is blocked. In response to the light blocking in the photosensor 46, the CPU 49 instructs the actuator 42 to raise the abutting rod 39 to a predetermined level along the Y axis.

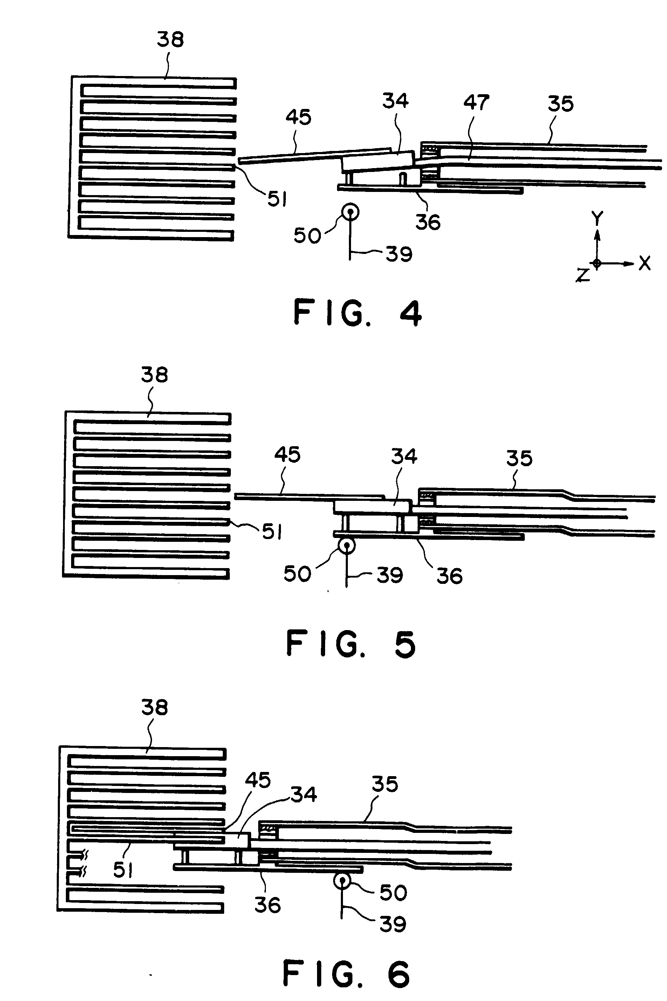

By the rising of the abutting rod 39, the hand locking plate 36 is moved upwardly. By this, the three prints on the hand working plate 36 raises the attracting hand 34, by which the wafer attracting surface of the attracting hand 34 is corrected so that the attitude of the wafer 45 is corrected to be substantially parallel to the X-Z plane. Then, the linear stage 33 is driven in the X axis direction, by which the hand locking plate 36 moves rolling on the roller 50 of the abutting rod 39, while it is maintained at an upper level by the abutting rod 39. Therefore, the wafer 45 can be accommodated into the wafer cassette 38 without contact to the accommodating shelf 51 (Figure 4) or the like of the wafer cassette 38. The wafer cassette 38 is movable substantially vertically (Y axis direction) by an unshown mechanism.

The operation for picking the wafer 45 out of the wafer cassette 38 is similar to the wafer returning operation. Immediately before the wafer cassette 38, the attitude of the attracting hand 34 is corrected, and then, it is inserted into the wafer cassette 38 to the accommodating position by the linear stage 33. The wafer 45 is then attracted by a known fashion and it is taken out.

Figures 4, 5 and 6 are side views of the apparatus, which show the wafer 45 returning operation into the wafer cassette 38 in more detail. Referring to these Figures, the relations among the attracting hand 34, the parallel link mechanism 35, the hand locking plate 36 and the abutting rod 39.

In Figure 4, the wafer 45 is moved by the linear stage 33 to a position immediately before the wafer cassette 38 and is stopped there. The attracting hand 34 supported on the elastic member 47 is flexed, and if the wafer is inserted into the wafer cassette as it is, the wafer 45 and the attracting hand 34 are contacted to the accommodating shelf 51 or the like of the wafer cassette 38.

Figure 5 shows the state wherein the abutting rod 39 is raised by the actuator 42 through a predetermined distance and is pressing up the hand locking plate 36. The attracting hand 34 is raised by the pins on the locking plate 36, and the attitude thereof is parallel to the attitude initial set by the parallel link 35. The wafer accommodating shelf 51 of the wafer cassette 38 is pre-adjusted so as to be parallel to the attitude of the wafer 45 (after correction) when it is urged upwardly.

Figure 6 shows the state wherein the attracting hand 34 is moved horizontally by the linear stage 33 from the state shown in Figure 5. The abutting rod 39 continues to urge the hand locking plate 36 upwardly, and therefore, the wafer 45 is inserted into the wafer cassette 38 with the attitude thereof is corrected. Therefore, the wafer 45 and the accommodating shelf 51 of the wafer cassette 38 are not contacted.

According to this embodiment, the attitude of the wafer is corrected immediately before the wafer cassette 38 by the attitude correcting mechanism mounted to the mounting plate 40 to which the cassette table 37 is also mounted. Therefore, the positioning error is smaller as compared even with the case where the supporting member 47 for the attracting hand 34 is highly rigid, for example. Thus, the wafer 45 can be transferred to and from the wafer cassette 38 without contact thereto.

As described in the foregoing, according to this embodiment, the attitude correcting means is disposed between the substrate accommodating portion and the conveying hand, and therefore, the possible dust production attributable to the contact between the substrate or the like and the accommodating portion can be prevented when the substrate such as a wafer is transferred to and from the accommodating portion. In addition, the substrate transfer to and from the accommodating portion can be performed with high precision. In addition, since the structure is simple, the assembling is easy, and the cost is low.

## Claims

1. A substrate conveying apparatus for conveying a substrate (1) to a chuck (2, 21) having a substrate supporting surface for holding said substrate (1), the apparatus comprising:
a stage (6, 7, 9, 10), including actuating means (9, 10);
supporting means (4, 5) mounted on said stage and integrally movable with said stage (6, 7, 9, 10) upon actuation of said actuating means; and
an operating hand (3) connected to said supporting means for supporting a substrate (1);
said stage being movable in a direction substantially perpendicular to the substrate supporting surface;
characterised in that said supporting means (4, 5) and said operating hand (3) are connected by a gimbal mechanism (23) comprising a first rotation shaft (17) mounted on said supporting means (4, 5) and extending in a first direction (X) substantially parallel to the substrate supporting surface;
a supporting hand (11), attached to said first rotation shaft (17), freely rotatable about said first shaft (17); and
a second rotation shaft (16) mounted on said supporting hand (11) and extending in a second direction (Y), perpendicular to the first direction (X) and substantially parallel to the substrate supporting surface, said operating hand (3) being attached to said second rotation shaft (16) and being freely rotatable about said shaft (16) wherein said operating hand (3) is rotatable, upon actuation of said actuating means, for positioning the substrate against the substrate supporting surface when the substrate is to be held by said chuck.

2. An apparatus according to claim 1, wherein said substrate is conveyable with a surface thereof in a vertical position.

3. A substrate conveying apparatus having a conveying hand (34) for conveying a substrate (45) to a substrate accommodating portion (38, 51) for accommodating said substrate (45), said conveying hand (34) being supported by an elastic member (47);
characterised by correcting means (36, 39, 50) for correcting an attitude of said conveying hand (34) to prevent contact of the substrate (45) and the conveying hand (34) with said substrate accommodating portion (38, 51) during conveyance of the substrate (45) to said substrate accommodating portion (38, 51).

4. A semiconductor wafer manufacturing apparatus for transferring a pattern onto a substrate, said apparatus comprising a substrate conveying apparatus described in one of claims 1-3, said substrate being a semiconductor wafer.

## Patentansprüche

1. Substrattransportvorrichtung zum Transportieren eines Substrats (1) zu einem Spannkopf (2, 21) mit einer Aufnahmefläche zum Halten des Substrats (1), wobei die Vorrichtung aufweist
- einen Tisch (6, 7, 9, 10), einschließlich einer Betätigungsvorrichtung (9, 10),
- eine Haltevorrichtung (4, 5), die auf dem Tisch (6, 7, 9, 10) montiert ist und bei Betätigung der Betätigungsvorrichtung zusammen mit diesem bewegt wird, und
- eine Bedienungshand (3), die mit der Haltevorrichtung zum Halten des Substrats (1) verbunden ist,
wobei der Tisch im wesentlichen senkrecht zur Substrataufnahmefläche bewegt werden kann,
**dadurch gekennzeichnet**, daß die Haltevorrichtung (4, 5) und die Bedienungshand (3) durch einen Kardanmechanismus (23) miteinander verbunden sind, der aufweist
- eine erste Drehachse (17), die an der Haltevorrichtung (4, 5) montiert ist und sich in einer ersten Richtung (X) im wesentlichen parallel zur Substrataufnahmefläche erstreckt,
- einen Haltebügel (11), der an der ersten Drehachse (17) befestigt ist und sich um die erste Drehachse (17) frei drehen kann, und
- eine zweite Drehachse (16), die am Haltebügel (11) befestigt ist und sich in einer zweiten Richtung (Y), senkrecht zur ersten Richtung (X) und im wesentlichen parallel zur Substrataufnahmefläche erstreckt, wobei die Bedienungshand (3) an der zweiten Drehachse (16) befestigt ist, sich um diese Drehachse (16) frei drehen kann und sich bei Betätigung der Betätigungsvorrichtung dreht und dabei das Substrat auf der Substrataufnahmefläche positioniert, damit dieses vom Spannkopf gehalten wird.

2. Vorrichtung gemäß Anspruch 1, wobei das Substrat senkrecht transportierbar ist.

3. Substrattransportvorrichtung, das eine Transporthand (34) zum Transportieren eines Substrats (45) zu einem Substrataufnahmeabschnitt (38, 51) aufweist, wobei die Transporthand (34) von einem elastischen Bauelement (47) gestützt wird,
**gekennzeichnet durch** eine Korrekturvorrichtung (36, 39, 50) zum Korrigieren der Stellung der Transporthand (34), um eine Berührung des Substrats (45) und der Transporthand (34) mit dem Substrataufnahmeabschnitt (38, 51) während des Transportes des Substrats (45) zum Substrataufnahmeabschnitt (38, 51) zu verhindern.

4. Halbleiterwaferfertigungsvorrichtung zum Übertragen eines Musters auf ein Substrat, wobei die Vorrichtung die in den Ansprüchen 1-3 beschriebene Substrattransportvorrichtung aufweist und wobei das Substrat ein Halbleiterwafer ist.

## Revendications

1. Appareil de transport de substrat destiné à transporter un substrat (1) jusqu'à un plateau de serrage (2, 21) présentant une surface de support de substrat destinée à maintenir ledit substrat (1), l'appareil comportant :
une platine (6, 7, 9, 10) comprenant des moyens d'actionnement (9, 10) ;
des moyens de support (4, 5) montés sur ladite platine et mobiles d'un seul bloc avec ladite platine (6, 7, 9, 10) lors d'un actionnement desdits moyens d'actionnement et
une main (3) de manoeuvre reliée auxdits moyens de support pour supporter un substrat (1) ;
ladite platine étant mobile dans une direction sensiblement perpendiculaire à la surface de support de substrat ;
caractérisé en ce que lesdits moyens de support (4, 5) et ladite main de manoeuvre (3) sont reliés par un mécanisme (23) à cardan comportant un premier axe (17) de rotation monté sur lesdits moyens de support (4, 5) et s'étendant dans une première direction (X) sensiblement parallèle à la surface de support de substrat ;
une main (11) de support reliée audit premier axe (17) de rotation et pouvant tourner librement autour dudit premier axe (17) ; et
un second axe (16) de rotation monté sur ladite main (11) de support et s'étendant dans une seconde direction (Y) perpendiculaire à la première direction (X) et sensiblement parallèle à la surface de support de substrat, ladite main (3) de manoeuvre étant reliée audit second axe (16) de rotation et pouvant tourner librement autour dudit axe (16), grâce à quoi ladite main (3) de manoeuvre peut tourner, lors de l'actionnement desdits moyens d'actionnement, de façon à positionner le substrat contre la surface de support du substrat lorsque le substrat doit être maintenu par ledit plateau de serrage.

2. Appareil selon la revendication 1, dans lequel ledit substrat peut être transporté de manière à présenter une surface dans une position verticale.

3. Appareil de transport de substrat ayant une main (34) de transport pour transporter un substrat (45) jusqu'à une partie (38, 51) de réception de substrat destinée à recevoir ledit substrat (45), ladite main (34) de transport étant supportée par un élément élastique (47) ;
caractérisé par des moyens de correction (36, 39, 50) destinés à corriger une attitude de ladite main (34) de transport pour empêcher l'entrée en contact du substrat (45) et de la main (34) de transport avec ladite partie (38, 51) de réception de substrat pendant le transport du substrat (45) jusqu'à ladite partie (38, 51) de réception de substrat.

4. Appareil de fabrication de tranches de semiconducteurs pour reporter un motif sur un substrat, ledit appareil comprenant un appareil de transport de substrat décrit dans l'une des revendications 1-3, ledit substrat étant une tranche de semiconducteurs.
